# EUROPÄISCHE PATENTANMELDUNG

(11) **EP 1 403 921 A2**
(43) Veröffentlichungstag der Anmeldung: **31.03.2004**
(21) Anmeldenummer: 03017506.1
(22) Anmeldetag: 04.08.2003
(51) Int. Cl.: H01L 21/98

(54) **Elektronisches Bauteil mit Halbleiterchips in einem Stapel und Verfahren zur Herstellung desselben**

(30) Priorität: 24.09.2002 DE 10244664
(71) Anmelder: Infineon Technologies AG, 81669 München (DE)
(72) Erfinder: Hagen, Robert-Christian, 93092 Sarching (DE); Wörner, Holger, 93049 Regensburg (DE)
(74) Vertreter: Schweiger, Martin

(57) **Zusammenfassung**

Elektronisches Bauteil mit Halbleiterchips in einem Stapel und Verfahren zur Herstellung desselben.

Die Erfindung betrifft sowohl ein Verfahren zur Herstellung eines elektronischen Bauteils (1) mit Halbleiterchips (2, 3) in einem Stapel (4) und als auch ein derartiges elektronisches Bauteil (1). Der Stapel (4) weist wenigstens einen ersten unteren Elektronikbaustein (9) auf, der über Flipchip-Verbindungen (8) mit einem Mittenbereich (7) eines Umverdrahtungssubstrats (5) verbunden ist. Der Stapel (4) weist weiterhin wenigstens einen zweiten oberen Elektronikbaustein (12) mit Außenkontaktflächen (14) auf, die über Bondverbindungen (11) mit Außenbereichen (10) des Umverdrahtungssubstrats (5) verbunden sind.

## Beschreibung

Elektronisches Bauteil mit Halbleiterchips in einem Stapel und Verfahren zur Herstellung desselben.

Die Erfindung betrifft ein elektronisches Bauteil mit Halbleiterchips in einem Stapel und ein Verfahren zu Herstellung desselben. Insbesondere betrifft die Erfindung ein elektronisches Bauteil mit einem Stapel aus einem Logikchip in Flipchip-Technologie und einem funktionsgetesteten Speicherbaustein in Bondtechnologie.

Das Bestreben immer höhere Schaltungsdichten zu erreichen, führt zu größerer Systemintegration, wobei zunehmend versucht wird, mehrere Halbleiterchips in einem Stapel anzuordnen. Dabei muß häufig ein komplettes Bauteil weggeworfen werden, nur weil der Speicherchip nicht funktioniert, obwohl der Logikchip an sich funktionsfähig ist.

Aufgabe der Erfindung ist es, ein Verfahren anzugeben, mit dem elektronische Bauteile mit Halbleiterchips in einem Stapel kostengünstig hergestellt werden können, und wobei die elektronischen Bauteile in Funktionstests verminderte Ausfallraten aufweisen.

Die Aufgabe wird mit dem Gegenstand der unabhängigen Ansprüche gelöst. Vorteilhafte Weiterbildungen der Erfindung ergeben sich aus den abhängigen Ansprüchen.

Erfindungsgemäß wird ein Verfahren zur Herstellung eines elektronischen Bauteils mit Halbleiterchips in einem Stapel geschaffen. Zunächst wird dazu ein Umverdrahtungssubstrat hergestellt, das Anschlussflächen für Flipchip-Verbindungen in einem Mittenbereich aufweist. Außerdem weist das Umverdrahtungssubstrat in seinen Randbereichen Anschlussflächen für Bondverbindungen auf. Damit ist das Umverdrahtungssubstrat in der Lage, sowohl Halbleiterchips in Flipchip-Technik als auch Halbleiterchips in Bondtechnik eines Stapels mit Außenkontakten des elektronischen Bauteils elektrisch zu verbinden. Auf dieses Umverdrahtungssubstrat, das in seinem Mittenbereich Anschlussflächen für Flipchip-Verbindungen aufweist, wird als nächstes ein als Halbleiterchip ausgebildeter erster Elektronikbaustein in Flipchip-Technologie aufgebracht.

Parallel dazu wird wenigstens ein zweiter Elektronikbaustein hergestellt, der zusätzlich zu seinem Halbleiterchip eine Umverdrahtungsstruktur mit Außenkontaktflächen aufweist. Dieser zweite Elektronikbaustein wird als oberer Baustein auf den ersten Elektronikbaustein so aufgebracht, dass die passiven Rückseiten des ersten und des zweiten Elektronikbausteins aufeinanderliegen. Anschließend werden Bondverbindungen zwischen den Außenkontaktflächen des zweiten oberen Elektronikbausteins und den Anschlussflächen in den Randbereichen des Umverdrahtungssubstrats hergestellt. Abschließend werden dann die gestapelten Elektronikbausteine unter Aufbringen einer Kunststoffgehäusemasse auf das Umverdrahtungssubstrat zu einem elektronischen Bauteil verpackt.

Dieses Verfahren hat den Vorteil, daß mit dem Aufbringen einer Umverdrahtungsstruktur auf die aktive Oberseite des Halbleiterchips des oberen Elektronikbausteins ein Zwischensubstrat geschaffen wird, das dem oberen Elektronikbaustein die nötige Stabilität für die Handhabung in einem Testverfahren verleiht. Auf die Außenkontaktflächen der Umverdrahtungsstruktur können dazu zumindest vorübergehend Außenkontakte aufgebracht werden, um die Funktionen des oberen Elektronikbausteins unabhängig von dem Stapel unter extremen Temperaturzyklen zu testen. Diese für vorgegebene Testsockel eventuell notwendigen Außenkontakte können vor dem Einbau des oberen Elektronikbausteins in den Stapel wieder entfernt werden, um die Außenkontaktflächen für ein Bonden beim Zusammenbau des elektronischen Bauteils zur Verfügung zu stellen.

Durch die erhöhte Stabilität des oberen Elektronikbausteins können die Bondverbindungen zwischen den randseitigen Außenkontakten der Umverdrahtungsstruktur des oberen Elektronikbausteins und den Anschlussflächen für Bondverbindungen in den Randbereichen des Umverdrahtungssubstrats nach dem Aufeinanderbringen der passiven Rückseiten der Elektronikbausteine unproblematisch und mit erhöhter Zuverlässigkeit hergestellt werden. Das spröde Material des Halbleiterchips des oberen Bausteins wird nämlich durch den Zwischenträger der Umverdrahtungsstruktur beim Bonden entlastet, so daß die Gefahr der Bildung von Mikrorissen in dem Halbleiterchip während des Bondens vermindert ist. Um eine Bondverbindung zu schaffen, weisen die Flächennormalen der Anschlussflächen für Bondverbindungen und die Flächennormalen der Außenkontaktflächen des oberen Elektronikbausteins in die gleiche Richtung.

Ein möglicher weiterer Vorteil des Verfahrens liegt darin, dass auch Bauteile mit größerer passiver Rückseite als die darunter angeordneten Halbleiterchips als zu bondende obere Elektronikbausteine eingesetzt werden können, weil die Stabilität der oberen Elektronikbausteine durch die Umverdrahtungsstruktur mit Zwischensubstrat im Bereich der zu bondenden Außenkontaktflächen erhöht ist und nicht auf dem Halbleiterchip, sondern auf dem Zwischensubstrat gebondet wird. Dieser Vorteil wirkt sich besonders aus, wenn als erster unterer Elektronikbaustein ein Logikchip eingesetzt wird und als zweiter oberer Elektronikbaustein ein flächenmäßig größerer Speicherchip verwendet wird.

Vor einem Aufbringen des oberen Elektronikbausteins auf die passive Rückseite des Halbleiterchips des unteren Elektronikbausteins kann somit der obere Elektronikbaustein Temperaturen von - 50°C bis 150°C ausgesetzt werden, wenn seine Funktionsfähigkeit getestet wird. Dabei wird der Baustein elektrisch in Betrieb gesetzt. Dazu kann die Umverdrahtungsstruktur mit ihren Außenkontaktflächen an das Rastermaß entsprechender Testsockel angepaßt sein. Durch die oben erwähnte vorübergehende Aufbringung von Außenkontakten auf die Außenkontaktflächen der Umverdrahtungsstruktur kann darüber hinaus eine verbesserte Kontaktierung zu den Testsockeln geschaffen werden. Nach dem Entfernen der vorübergehend angebrachten Außenkontakte stehen die Außenkontaktflächen für ein Anbringen von Bondverbindungen bei dem Zusammenbau des elektronischen Bauteils wieder zur Verfügung.

Erfindungsgemäß kann während eines Funktionstests auf sämtliche Signalanschlüsse des oberen Elektronikbausteins zugegriffen werden. Dementsprechend ist ein aussagekräftigeres Testergebnis möglich, zumal nach dem Zusammenbau des elektronischen Bauteils ein Zugriff auf alle Signalanschlüsse des oberen Elektronikbausteins unabhängig von den übrigen Elektronikbausteinen des Stapels nicht mehr möglich ist. Wird ein derartiger Funktionstest für den oberen Elektronikbaustein vor dem Zusammenbau des elektronischen Bauteils durchgeführt, so steigt die Gesamtausbeute und es ergeben sich erhebliche Kostenvorteile. Es wird nämlich mindestens einer oder beide der Elektronikbausteine vorgetestet, wodurch sichergestellt werden kann, daß auch Elektronikbausteine mit potentiell hoher Ausfallwahrscheinlichkeit wie etwa Speicherchips nur dann eingesetzt werden, wenn diese wie vorstehend beschrieben eingehend getestet wurden. Durch ein Stapeln von Elektronikbausteinen übereinander wird zusätzlich Raum eingespart, die Schaltungsdichte vergrößert, und die Kosten werden optimiert. Darüber hinaus werden die elektrischen Eigenschaften verbessert, da kurze Bondverbindungen realisiert werden, was mit einer Verminderung parasitärer Induktivitäten verbunden ist.

Die passiven Rückseiten der Elektronikbausteine können in vorteilhafter Weise aufeinander geklebt werden. Dazu können Leitkleber eingesetzt werden, beispielsweise wenn die Rückseiten der Elektronikbausteine auf gleichem Potential liegen sollen. Sind Potentialdifferenzen zwischen den Rückseiten der Elektronikbausteine vorgesehen, so können isolierende Klebstoffe eingesetzt werden.

Die Bondverbindungen zwischen den Außenkontakten des oberen Elektronikbausteins und den Anschlussflächen im Randbereich des Umverdrahtungssubstrats können mittels Thermokompressionsbonden hergestellt werden. Dabei wird auf einer der zu verbindenden Flächen ein Bondkopf gebildet, von dem aus der Bonddraht zunächst in Richtung der Flächennormale geführt wird, bevor er zu der zweiten Fläche hin gebogen werden kann und dort unter Bildung eines Bondbogens mit der zweiten Fläche elektrisch verbunden wird. Während der Bondbogen auf der zweiten Fläche fast tangential zu der Fläche angebracht werden kann, benötigt der Bondkopf mit dem abgebogenen Bonddraht eine Mindesthöhe über der gebondeten Fläche. Deshalb ist es vorteilhaft, wenn der Bondkopf zunächst auf der Anschlussfläche für die Bondverbindungen in dem Randbereich des Umverdrahtungssubstrats hergestellt wird, und erst danach der Bondbogen auf der Außenkontaktfläche der Umverdrahtungsstruktur des oberen Elektronikbausteins gebildet wird. Dadurch wird auch die Bauteilhöhe des elektronischen Bauteils mit Halbleiterchips in einem Stapel minimiert.

In die Umverdrahtungsstruktur des oberen Elektronikbausteins kann ein zentraler Bondkanal eingebracht sein. Die zentralen Bondverbindungen dieses zentralen Bondkanals werden über Bondfinger und über Umverdrahtungsleitungen elektrisch leitend mit den Außenkontaktflächen verbunden. Die Außenkontaktflächen können auf Randbereiche des oberen Elektronikbausteins verteilt werden, wodurch das Bonden zu den Anschlussflächen in den Randbereichen des Umverdrahtungssubstrats erleichtert und kurze Bonddrähtlängen ermöglicht werden.

Die zentralen Bondverbindungen in dem Bondkanal weisen gegenüber den Bondverbindungen auf den Außenkontaktflächen geringe Abmessungen auf, so dass sie bereits durch den Bondkanal insoweit ausreichend geschützt sind, dass der obere Elektronikbaustein mit offenem ungeschütztem Bondkanal einem Funktionstest vorsichtiger Handhabung ausgesetzt werden kann. Der Bondkanal kann jedoch in vorteilhafter Weise unter Einbetten der zentralen Bondverbindungen des Bondkanals von einer Schutzumhüllung aus Kunststoff bedeckt werden, bevor der obere Elektronikbaustein einem Funktionstest ausgesetzt wird. Dies hat den Vorteil, dass die Handhabung sowohl bei der Funktionsprüfung als auch bei dem späteren Zusammenbau erleichtert wird und eine Beschädigung der zentralen Bondverbindungen zuverlässig vermieden wird.

Als Umverdrahtungssubstrat kann eine beidseitig metallisierte Leiterplatte eingesetzt werden, deren Metallplattierungen auf ihrer Oberseite und auf ihrer Unterseite strukturiert werden. Die Struktur der Oberseite kann in einem Mittenbereich Kontaktanschlußflächen für Flipchip-Verbindungen aufweisen. In den Randbereichen der Oberseite können Anschlussflächen für Bondverbindungen geschaffen werden. Die strukturierte Metallplattierung auf der Unterseite der Leiterplatte kann Außenkontaktflächen aufweisen, die mit den Anschlussflächen über Durchkontakte und über Umverdrahtungsleitungen elektrisch verbunden werden können. Ein derartiges Umverdrahtungssubstrat auf der Basis einer beidseitig metallisierten und strukturierten Leiterplatte kann kostengünstig hergestellt werden und hat gegenüber Umverdrahtungssubstraten auf Keramikbasis einen erheblichen Preisvorteil.

Nach dem Aufbringen der zu stapelnden Elektronikbausteine auf ein derartig präpariertes Umverdrahtungssubstrat können die Elektronikbausteine mittels einem Transfermoldverfahren in ein gefülltes Epoxidharz eingebettet werden. Dieses Verpacken kann gleichzeitig für mehrere elektronische Bauteile durchgeführt werden, wenn das verwendete Umverdrahtungssubstrat entsprechend viele Bauteilpositionen aufweist, in denen Elektronikbausteine gestapelt und gebondet sind. Während beim Transfermoldverfahren die Bondverbindungen aufgrund des hohen Druckes und der Fließeigenschaften des gefüllten Epoxidharzes stark belastet werden, ist ein Verpacken der Elektronikbausteine in ein Kunststoffgehäuse mittels Dispensverfahren wesentlichen schonender.

Abschließend können auf die Außenkontaktflächen des Umverdrahtungssubstrats Außenkontakte aufgebracht werden. Diese Außenkontakte können Lötbälle aufweisen, wobei eine die Außenkontaktflächen umgebende Lötstopplackschicht ein Benetzen beispielsweise von Umverdrahtungsleitungen durch das Material der Außenkontakte verhindert.

Die Erfindung betrifft auch ein elektronisches Bauteil mit Halbleiterchips in einem Stapel, das ein Umverdrahtungssubstrat umfaßt. In einem Mittenbereich des Umverdrahtungssubstrats sind Anschlussflächen für Flipchip-Verbindungen vorgesehen. In seinen Randbereichen weist das Umverdrahtungssubstrat Anschlussflächen für Bondverbindungen auf. Kontaktbereiche eines als Halbleiterchip ausgebildeten ersten unteren Elektronikbausteins sind mit den Anschlussflächen in dem Mittenbereich des Umverdrahtungssubstrats verbunden. Ein zweiter oberer Elektronikbaustein weist einen Halbleiterchip mit einer Umverdrahtungsstruktur und mit Außenkontaktflächen auf. Der obere Elektronikbausteine ist derart auf dem unteren Elektronikbaustein angeordnet, dass die passiven Rückseiten der Elektronikbausteine aufeinanderliegen. Zur elektrischen Verbindung des oberen Elektronikbausteins mit dem Umverdrahtungssubstrat sind zwischen den Außenkontaktflächen des oberen Elektronikbausteins und den Anschlussflächen in den Randbereichen des Umverdrahtungssubstrats Bondverbindungen vorgesehen.

Der Stapel aus mindestens einem Halbleiterchip in Flipchip-Technologie und aus einem Elektronikbaustein mit einer Umverdrahtungsstruktur und mit Außenkontaktflächen ist von einem Bauteilgehäuse umgeben. Ein elektronisches Bauteil aus einer Kombination aus einem Halbleiterchip als ersten unteren Elektronikbaustein und aus einem weitgehend gehäusten zweiten oberen Elektronikbaustein hat den Vorteil, dass die Außenkontaktflächen des oberen Elektronikbausteins eingesetzt werden können, um vor einem Zusammenbau zu einem elektronischen Bauteil die Funktionsfähigkeit des weitgehend gehäusten oberen Elektronikbausteins unter extremen Temperaturbedingungen zu testen, so daß eine zuverlässige Aussage darüber getätigt werden kann, ob der Stapel wenigstens einen vollständig funktionsfähigen oberen Elektronikbaustein aufweist. Durch das Stapeln wird der Platzbedarf vermindert und die Schaltungsdichte erhöht. Durch die Möglichkeit einer separaten Funktionsprüfung des oberen Elektronikbausteins ergibt sich eine Kostenoptimierung und eine zuverlässige Prognostizierbarkeit der endgültigen elektrischen Eigenschaften des elektronischen Bauteils.

Diese Vorteile wirken sich besonders aus, wenn der untere Elektronikbaustein ein Logikchip und der obere Elektronikbaustein ein Speicherchip mit Umverdrahtungsstruktur und mit Außenkontaktflächen ist. Derartige Speicherchips weisen eine relativ hohe Ausfallrate bei Funktionstests mit extremen Temperaturen zwischen -50°C und 150°C auf. Diese Ausfallrate kann für das elektronische Bauteil mit einem Stapel aus einem Logikchip und aus einem Speicherchip vermindert werden, wenn der Speicherchip bereits eine Umverdrahtungsstruktur mit Außenkontakflächen aufweist, durch die ein unabhängiger vollständiger Funktionstest vor einem weiteren Stapelbau möglich wird.

Ein weiterer Vorteil besteht darin, dass die Außenkontaktflächen des oberen Elektronikbausteins auf Grund der Verdrahtungstruktur in die Randbereiche des oberen Elektronikbausteins gelegt werden können, sodass äußerst kurze Bondverbindungen von den Außerkontaktflächen zu den Anschlussflächen in den Randbereichen des Umverdrahtungssubstrats möglich werden. Durch die kurzen Bondverbindungen wird eine ausreichende Bonddrahtstabilität erreicht, sodass als Material für das Kunststoffgehäuse ein hochgefülltes Epoxidharz eingesetzt werden kann, ohne besondere Vorkehrungen für den Schutz der Bondverbindungen zu treffen.

Die Umverdrahtungsstruktur mit ihrem Zwischensubstrat und den Außenkontaktflächen auf dem oberen Elektronikbaustein vergrößert gleichzeitig die mechanische Stabilität dieses Elektronikbausteins, wodurch die gesamte Zuverlässigkeit des elektronischen Bauteils erhöht ist, zumal die Gefahr von Mikrorissbildungen in dem Halbleiterchip beim Bonden dadurch vermindert wird, daß nicht unmittelbar auf dem Halbleiterchip gebondet wird.

Das Umverdrahtungssubstrat weist eine beidseitig metallisierte und strukturierte Leiterplatte auf. Diese Leiterplatte verfügt über Durchkontakte als elektrische Verbindung zwischen den strukturierten Metallschichten auf der Ober- und auf der Unterseite der Leiterplatte. Die Unterseite der Leiterplatte weist Außenkontaktflächen für Außenkontakte auf. Die Oberseite der Leiterplatte weist in ihrem Mittenbereich die Anschlussflächen für die Flipchip-Verbindungen und in ihren Randbereichen die Anschlussflächen für Bondverbindungen auf. Die Außenkontaktflächen auf der Unterseite der Leiterplatte sind über Durchkontakte und über Umverdrahtungsleitungen mit den Anschlussflächen auf der Oberseite elektrisch verbunden. Ein derartiges Umverdrahtungssubstrat auf der Basis einer Leiterplatte ist kostengünstig herstellbar verglichen mit Umverdrahtungsfolien oder Umverdrahtungssubstraten auf der Basis von Keramiken.

Zwischen den aufeinanderliegenden passiven Rückseiten der Elektronikbausteine ist eine Klebstoffschicht angeordnet. Wenn die Klebstoffschicht einen Leitkleber aufweist, können die Rückseiten der Elektronikbausteine auf gleichem Potential liegen. Eine Klebstoffschicht aus Isolationsklebstoff kann beispielsweise dann zwischen beiden Rückseiten der Elektronikbausteine vorgesehen werden, wenn eine Potentialdifferenz zwischen beiden Elektronikbausteinen an den Rückseiten gewünscht ist.

Der obere Elektronikbaustein weist auf seiner aktiven Oberseite einen zentralen Bondkanal mit zentralen Bondverbindungen auf. Diese zentralen Bondverbindungen sind über die auf der aktiven Oberseite angeordnete Umverdrahtungsstruktur mit den Außenkontaktflächen verbunden. Dieser Bondkanal kann eine Schutzumhüllung für seine zentralen Bondverbindungen aufweisen, wodurch sich eine Materialgrenze zwischen einer derartigen Schutzumhüllung und dem Kunststoffgehäuse des elektronischen Bauteils ausbildet. Ein derartiger Bondkanal mit zentralen Bondverbindungen wird insbesondere für Speicherchips eingesetzt, um die relativ große aktive Oberseite der Speicherchips zu beiden Seiten des Bondkanals für das Anordnen von Außenkontaktflächen zu nutzen.

Die Bondverbindungen zwischen den Außenkontaktflächen und den Anschlussflächen der Außenbereiche des Umverdrahtungssubstrats können einen Bonddraht aufweisen, der sich in einen Bondkopf und in einen Bondbogen gliedert. Der Bondkopf kann auf einer der Anschlussflächen des Umverdrahtungssubstrats angeordnet sein, während der Bondbogen auf der entsprechenden Außenkontaktfläche des oberen Elektronikbausteins angeordnet ist. Diese Ausführung der Bondverbindungen hat den Vorteil, dass für den Bondbogen eine geringere Höhe beansprucht wird, als für den Bondkopf, so daß die Gesamthöhe des elektronischen Bauteils minimiert werden kann.

Weiterhin ist vorgesehen, dass zwischen der aktiven Oberseite des Halbleiterchips des unteren Elektronikbausteins bei den Kontaktbereichen und der Oberseite des Umverdrahtungssubstrats ein Zwischenraum ausgebildet ist. Dieser Zwischenraum ist mit einem Unterfüllstoff aufgefüllt, der einen hochgefüllten Kunststoff mit einem Füllgrad von 80 bis 95 Gew.% aufweist. Dieser hohe Füllgrad des Unterfüllstoffes ermöglicht eine weitgehende Anpassung des thermischen Ausdehnungsverhaltens des Unterfüllstoffes an das thermische Ausdehnungsverhalten des Halbleiterchips.

Zusammenfassend ist festzustellen, dass ein Speicherchip beispielsweise in einem BOC-Gehäuse (board on chip package) als zweiter oberer Baustein in einem elektronischen Bauteil eingesetzt werden kann, bevor er mit seiner freibleibenden Chiprückseite auf einen Logikchip in Flipchip-Technik geklebt wird, in seinem Gehäuse bereits geburnt bzw. extremen Temperaturen ausgesetzt und getestet werden kann. Durch Optimieren des Bondprozesses beim Verbinden des oberen Speicherchips mit dem Umverdrahtungssubstrat kann außerdem eine raumsparende Stapelung eines Speicherchips auf einem Logikchip erreicht werden.

Durch die auf dem Speicherchip angebrachte Umverdrahtungsstruktur mit ihrem Zwischensubstrat entsteht bezüglich Design und Routing bzw. Umverdrahtungsführung ein sehr flexibles Gehäusekonzept. Dieses Gehäuse des oberen Speicherchips erleichtert die Anpassung beim Verwenden von Speicherbausteinen verschiedener Zulieferer oder bei Technologieänderungen, da über die Umverdrahtungsstruktur Anpassungen vorgenommen werden können, ohne dass Veränderungen des Umverdrahtungssubstrats mit dem unteren Flipchip-Baustein vorgenommen werden müssen. Somit ergibt sich ein kostengünstiger, flexibler und anpassungfähiger Aufbau zum Stapeln eines Elektronikbausteins in Flipchip-Technologie mit einem Elektronikbaustein in Bond-Technologie.

Die Erfindung wird nun anhand der beigefügten Figuren näher erläutert.
- Figur 1: zeigt einen schematischen Querschnitt eines elektronischen Bauteils gemäß einer ersten Ausführungsform der Erfindung,
- Figur 2: zeigt einen schematischen Querschnitt eines elektronischen Bauteils einer zweiten Ausführungsform der Erfindung,
- Figur 3: zeigt einen schematischen Querschnitt eines elektronischen Bauteils einer dritten Ausführungsform der Erfindung,
- Figur 4: zeigt einen schematischen Querschnitt eines elektronischen Bauteils einer vierten Ausführungsform der Erfindung,
- Figuren 5 bis 11: zeigen schematische Querschnitte von Zwischenprodukten bei der Herstellung des elektronischen Bauteils gemäß der ersten Ausführungsform der Erfindung,

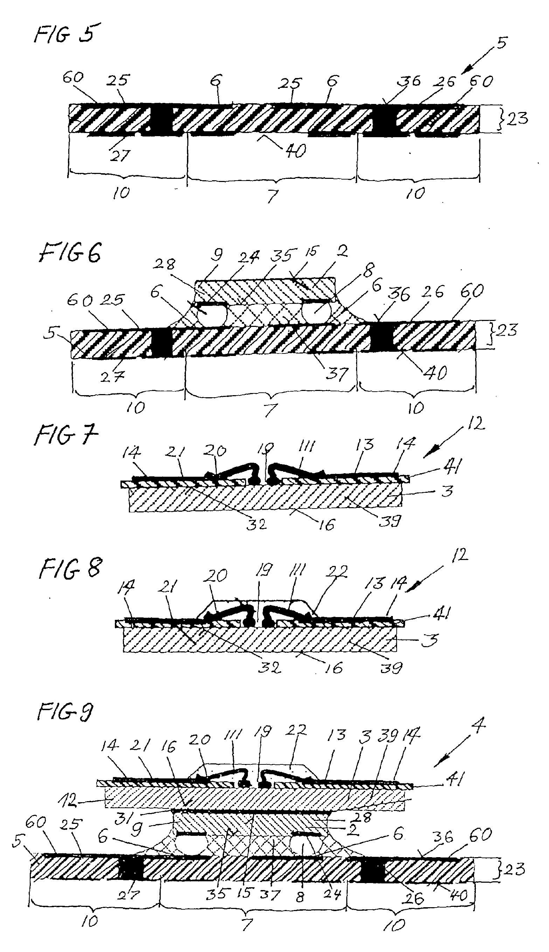

- Figur 5: zeigt einen schematischen Querschnitt eines Umverdrahtungssubstrats,
- Figur 6: zeigt einen schematischen Querschnitt eines Umverdrahtungssubstrats mit einem aufgebrachten ersten Elektronikbaustein,
- Figur 7: zeigt einen schematischen Querschnitt eines zweiten Elektronikbausteins mit einem ungeschützten Bondkanal,
- Figur 8: zeigt einen schematischen Querschnitt des zweiten Elektronikbausteins aus Fig.7 mit einem geschützten Bondkanal,
- Figur 9: zeigt einen schematischen Querschnitt durch einen Stapel mit dem erstem Elektronikbaustein und mit dem zweitem Elektronikbaustein auf dem Umverdrahtungssubstrat aus Figur 5,

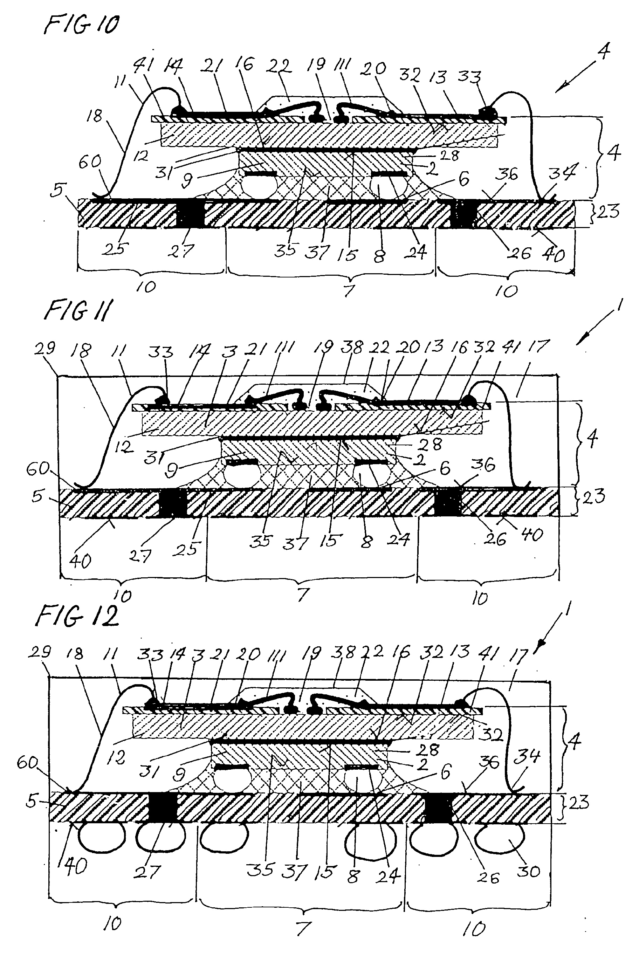

- Figur 10: zeigt einen schematischen Querschnitt durch einen Stapel aus Figur 9 nach Aufbringen von Bondverbindungen,
- Figur 11: zeigt einen schematischen Querschnitt durch ein elektronisches Bauteil nach Verpacken des Stapels aus Figur 10 in einem Bauteilgehäuse,
- Figur 12: zeigt einen schematischen Querschnitt durch ein elektronisches Bauteil nach Aufbringen von Außenkontakten auf das Umverdrahtungssubstrat des elektronischen Bauteils.

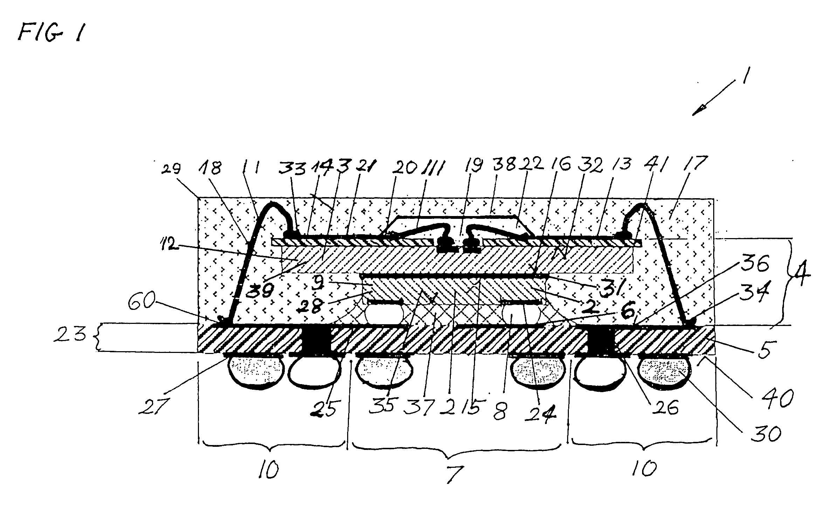

Figur 1 zeigt einen schematischen Querschnitt eines elektronischen Bauteils 1 einer ersten Ausführungsform der Erfindung. Die Basis dieses elektronischen Bauteils 1 bildet ein Umverdrahtungssubstrat 5 mit einer Oberseite 36 und mit einer Unterseite 40, die gleichzeitig die Unterseite des elektronischen Bauteils 1 bildet. Auf der Unterseite 40 sind Außenkontakte 30 in Form von Kontaktbällen angeordnet, die auf Außenkontaktflächen 27 des Umverdrahtungssubstrats 5 gelötet sind. Diese Außenkontaktflächen 27 des Umverdrahtungssubstrats 5 sind über Durchkontakte 26 und über Umverdrahtungsleitungen 25 des Umverdrahtungssubstrats 5 mit Anschlussflächen 6 und 60 auf der Oberseite 36 des Umverdrahtungssubstrats 5 verbunden. Das Umverdrahtungssubstrat 5 weist in dieser ersten Ausführungsform der Erfindung eine Leiterplatte 23 als Trägermaterial auf.

In einem Mittenbereich 7 sind auf der Oberseite 36 des Umverdrahtungssubstrats 5 Anschlussflächen 6 zum Verbinden mit Flipchip-Kontakten angeordnet. In den Randbereichen 10 sind auf der Oberseite 36 des Umverdrahtungssubstrats 5 Anschlussflächen 60 für Bondverbindungen angeordnet. Auf den Anschlussflächen 6 des Mittenbereichs 7 ist wenigstens ein Logikchip 28 mit seinen Kontaktbereichen 24 über die Flipchip-Verbindungen 8 als ein erster unterer Elektronikbaustein 9 aufgebracht. Auf der passiven Rückseite 15 dieses ersten Elektronikbausteins 9 ist eine Klebeschicht 31 angeordnet, mit der ein zweiter oberer Elektronikbaustein 12 auf dem ersten unteren Elektronikbaustein 9 angeordnet ist.

Bei dem zweiten Elektronikbaustein 12 handelt es sich um einen Speicherchip 39, der einen zentralen Bondkanal 19 auf seiner aktiven Oberseite 32 mit zentralen Bondverbindungen 111 aufweist. Diese zentralen Bondverbindungen 111 des Bondkanals 19 sind über Bondfinger 20 der Umverdrahtungsstruktur 13 mit Außenkontaktflächen 14 des oberen Elektronikbausteins 12 verbunden. Die Umverdrahtungsstruktur 13 weist ein Zwischensubstrat 41 auf, auf dessen Randbereichen die Außenkontaktflächen 14 angeordnet sind. Die Außenkontaktflächen 14 sind über Bondköpfe 33 von Bonddrähten 18 mit den Anschlussflächen 60 in dem Randbereich 10 des Umverdrahtungssubstrats 5 unter Ausbildung eines Bondbogens 34 verbunden.

Ein Bauteilgehäuse 29 umgibt diesen Stapel 4 aus mindestens einem unteren Logikchip 28 und einem oberen Speicherchips 39 sowie die Bondverbindungen 18 zwischen dem oberen Speicherchip 39 und dem Umverdrahtungssubstrat 5. Ein Unterfüllstoff 37, der einen hochgefüllten Kunststoff mit einem Füllgrad zwischen 80 und 95 Gew.% aufweist, füllt einen Zwischenraum zwischen der aktiven Oberseite 35 des Logikchips 28 und der Oberseite 36 des Umverdrahtungssubstrats 5 und bettet die Kontaktbereiche 24 des Logikchips 28 ein. Der hohe Füllgrad sorgt für eine weitgehende Anpassung des thermischen Ausdehnungsverhaltens des Unterfüllstoffes 37 an das thermische Ausdehnungsverhalten des Halbleitermaterials des Logikchips 28. Eine Schutzumhüllung 22 deckt den Bondkanal 19 ab und schützt die zentralen Bondverbindungen 111 des Speicherchips 39. Zwischen der Schutzumhüllung 22 und der umgebenden Kunststoffgehäusemasse 17 des Bauteilgehäuses 29 bildet sich eine Materialgrenze 38 aus.

Dieses elektronische Bauteil 1 weist somit einen Stapel 4 aus einem Halbleiterchip 2 in Flipchip-Technologie und aus einem nahezu vollständig gehäusten Elektronikbaustein 12 auf. Die Funktionsfähigkeit dieses Elektronikbausteins 12 ist vor seinem Einbau in das elektronische Bauteil 1 unter extremen Temperaturen zwischen -50 und 150 °C getestet worden. Dieser Funktionsfähigkeitstest kann durchgeführt werden, indem entweder die Außenkontaktflächen 14 des oberen Elektronikbausteins 12 mit einem entsprechenden Prüfsockel verbunden werden oder indem Außenkontakte vorübergehend auf die Außenkontaktflächen 14 aufgebracht werden, die nach dem Test und vor dem Einbau in das elektronische Bauteil 1 wieder entfernt werden.

In einem hier nicht gezeigten Ausführungsbeispiel ist der Unterfüllstoff 37 weggelassen, wobei der Spalt zwischen der aktiven Oberseite 35 und der Oberseite 36 mit der Kunststoffgehäusemasse 17 aufgefüllt sind.

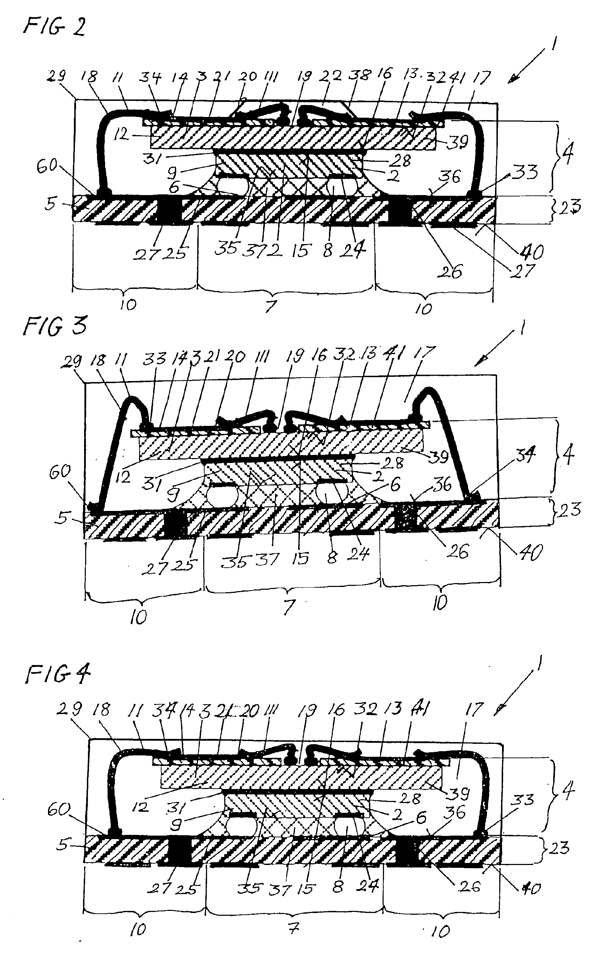

Figur 2 zeigt einen schematischen Querschnitt eines elektronischen Bauteils 1 gemäß einer zweiten Ausführungsform der Erfindung. Komponenten mit gleichen Funktionen wie in Figur 1 werden mit gleichen Bezugszeichen gekennzeichnet und nicht extra erörtert.

Ein Unterschied zwischen dem elektronischen Bauteil 1 aus Figur 1 zu dem elektronischen Bauteil 1 der zweiten Ausführungsform der Erfindung besteht darin, dass die Bonddrähte 18 der Bondverbindungen 11 mit ihren Bauteilhöhe beanspruchenden Bondköpfen 33 auf den Anschlussflächen 60 in den Randbereichen 10 des Umverdrahtungssubstrats 5 angeordnet sind. Der relativ flache Bondbogen 34 einer derartigen Bondverbindung 11 ist auf den Außenkontakten 14 des oberen Elektronikbausteins 12 angeordnet. Dadurch ist es möglich, die Bauteilhöhe des elektronischen Bauteils 1 durch die Schutzumhüllung 22 des Bondkanals 19 zu begrenzen. Das elektronische Bauteil 1 weist somit eine geringere Höhe auf als das elektronische Bauteil 1 aus Figur 1. Die Materialgrenze 38 zwischen der Kunststoffgehäusemasse 17 und dem Kunststoff der Schutzumhüllung 22 des Bondkanals 19 ist somit auf die Randseiten der Schutzumhüllung 22 begrenzt.

Figur 3 zeigt einen schematischen Querschnitt eines elektronischen Bauteils 1 gemäß einer dritten Ausführungsform der Erfindung. Komponenten mit gleichen Funktionen wie in den vorhergehenden Figuren werden mit gleichen Bezugszeichen gekennzeichnet und nicht extra erörtert.

Der Aufbau des Stapels aus den Elektronikbausteinen 9 und 12 ist bei der dritten Ausführungsform der Erfindung der gleiche wie bei der ersten Ausführungsform der Erfindung aus Figur 1. Jedoch wird hier der Bondkanal 19 des oberen Elektronikbausteins 12 von der Kunststoffgehäusemasse 17 bedeckt, sodass sich keine Materialgrenze 38 gemäß Figur 1 ausbildet. In diesem elektronischen Bauteil 1 wird beim Zusammenbau der Verfahrensschritt zum Einbetten der zentralen Bondverbindungen 111 des Bondkanals 19 in eine Schutzumhüllung 22 eingespart. Dennoch ist der obere Elektronikbaustein 12 vor dem Einbau in ein derartiges elektronisches Bauteil 1 auf Funktionsfähigkeit testbar. Er weist die für den Funktionstest notwendigen Außenkontaktflächen 14 auf.

Figur 4 zeigt einen schematischen Querschnitt eines elektronischen Bauteils 1 einer vierten Ausführungsform der Erfindung. Komponenten mit gleichen Funktionen wie in den vorhergehenden Figuren werden mit gleichen Bezugszeichen gekennzeichnet und nicht extra erörtert.

Der innere Aufbau dieses elektronischen Bauteils 1 der vierten Ausführungsform der Erfindung entspricht dem Aufbau des elektronischen Bauteils 1 aus Figur 2. Jedoch ist die Schutzumhüllung 22 des Bondkanals 19 für den oberen Elektronikbaustein 12 aus Gründen der Kostenersparnis weggelassen. Damit wird ein elektronisches Bauteil 1 mit einer minimalen Bauteilhöhe kostengünstig realisiert.

Die Figuren 5 bis 12 zeigen schematische Querschnitte von Zwischenprodukten bei der Herstellung eines elektronischen Bauteils 1 gemäß der ersten Ausführungsform der Erfindung. Komponenten mit gleichen Funktionen wie in den vorhergehenden Figuren werden in den Figuren 5 bis 12 mit gleichen Bezugszeichen gekennzeichnet und nicht extra erörtert.

Figur 5 zeigt einen schematischen Querschnitt eines Umverdrahtungssubstrats 5. Dieses Umverdrahtungssubstrat 5 ist aus einer beidseitig metallisierten und beidseitig strukturierten Leiterplatte 23 gefertigt. Die Metallstruktur der Oberseite 36 der Leiterplatte 23 ist mit der Metallstruktur auf der Unterseite 40 der Leiterplatte 23 über Durchkontakte 26 verbunden. Die Unterseite 40 der Leiterplatte 23 weist Außenkontaktflächen 27 auf, die in 3 Ringen auf der Unterseite 40 der Leiterplatte 23 angeordnet sind. Auf der Oberseite 36 der Leiterplatte 23 sind Umverdrahtungsleitungen 21 angeordnet, die mit den Durchkontakten 26 elektrisch verbunden sind. Außerdem verbinden die Umverdrahtungsleitungen 21 die Durchkontakte 26 und damit die Außenkontaktflächen 27 mit Anschlussflächen 6 für die Flipchip-Verbindungen 8 in einem Mittenbereich 7 der Leiterplatte 23 und/oder mit Anschlussflächen 60 für die Bondverbindungen 18 in Randbereichen 10 der Leiterplatte 23.

Figur 6 zeigt einen schematischen Querschnitt eines Umverdrahtungssubstrats 5 mit einem aufgebrachten ersten Elektronikbaustein 9. Dieser Elektronikbaustein 9 ist über Flipchip-Verbindungen 8 mit den Anschlussflächen 6 des Mittenbereichs 7 des Umverdrahtungssubstrats 5 verbunden. Der Zwischenraum zwischen der aktiven Oberseite 35 des ersten unteren Elektronikbausteins 9 und der Oberseite 36 des Umverdrahtungssubstrats 5 ist mit einem Unterfüllstoff 37 aufgefüllt.

Figur 7 zeigt einen schematischen Querschnitt eines Elektronikbausteins 12 mit einem ungeschützten Bondkanal 19. Dieser zweite Elektronikbaustein 12 weist zusätzlich zu einem Halbleiterchip 3, der hier ein Speicherchip 39 ist, eine Umverdrahtungsstruktur 13 mit einem Zwischensubstrat 41 auf. Darüber hinaus weist dieser zweite Elektronikbaustein 12 einen Bondkanal 19 mit zentralen Bondverbindungen 111 auf, die über die Umverdrahtungsstruktur 13 mit Außenkontaktflächen 14 des Elektronikbausteins 12 verbunden sind.

Ein derartig vorbereiteter Elektronikbaustein 12 wird vor dem Einbau in ein elektronisches Bauteil extremen Temperaturen zwischen -50 und 150 °C ausgesetzt, während seine Funktionsfähigkeit geprüft wird. Dieser Funktionstest erfolgt auch, ohne daß die zentralen Bondverbindungen 111 in dem Bondkanal 19 bereits durch eine Schutzumhüllung geschützt sind.

Figur 8 zeigt einen schematischen Querschnitt des zweiten Elektronikbausteins 12 aus Figur 7 mit einem geschützten Bondkanal 19. Die Handhabung des zweiten Elektronikbausteins 12 ist aufgrund des geschützten Bondkanals 19 gegenüber der Handhabung eines Elektronikbausteins 12 mit einem ungeschützten Bondkanals 19, wie ihn Figur 7 zeigt, erleichtert und sicherer. Die empfindlichen zentralen Bondverbindungen 111 sind nämlich in der Schutzumhüllung 22 eingebettet und vor mechanischer Beschädigung bei der Handhabung geschützt.

Figur 9 zeigt einen schematischen Querschnitt durch einen Stapel 4 eines ersten und zweiten Elektronikbausteins 9 bzw. 12 auf dem Umverdrahtungssubstrat 5 aus Figur 5. Dazu wird der in Figur 7 oder der in Figur 8 gezeigte vollständig funktionsgetestete zweite Elektronikbaustein 12 mit seiner passiven Rückseite 16 mittels einer Klebstoffschicht 31 auf die passive Rückseite 15 des Elektronikbausteins 9 geklebt.

Figur 10 zeigt einen schematischen Querschnitt durch einen Stapel 4 aus Figur 9 nach dem Aufbringen von Bondverbindungen 11. Diese Bondverbindungen 11 sind auf die Außenkontaktflächen 14 der Umverdrahtungsstruktur 13 des oberen Elektronikbausteins 12 aufgebracht. Dazu wird zunächst ein Bondkopf 33 auf den Außenkontaktflächen 14 gebondet und der Bonddraht 18 nach unten zu den Anschlussflächen 60 des Umverdrahtungssubstrats 5 geführt. Unter Bilden eines Bondbogens 34 werden dann die Bonddrähte 18 mit den Anschlussflächen 60 verbunden.

Figur 11 zeigt einen schematischen Querschnitt durch ein elektronisches Bauteil 1 nach einem Verpacken des Stapels 4 aus Figur 10 in einem Bauteilgehäuse 29. Dabei bildet das Umverdrahtungssubstrat 5 mit seiner Unterseite 40 gleichzeitig die Unterseite des elektronischen Bauteils 1. Außerdem bildet sich eine Materialgrenze 38 zwischen dem Material der Schutzumhüllung 22 des Bondkanals 19 und der Kunststoffgehäusemasse 17 aus.

Figur 12 zeigt einen schematischen Querschnitt durch ein elektronisches Bauteil 1 nach Aufbringen von Außenkontakten 30 auf das Umverdrahtungssubstrat 5. Diese Außenkontakte 30 sind hier als Kontaktbälle ausgebildet und in 3 Ringen angeordnet. Dazu werden lötbare Kontaktbälle auf die Außenkontaktflächen 27 auf der Unterseite 40 der Umverdrahtungsstruktur 5 aufgelötet.

## Patentansprüche

1. Verfahren zur Herstellung eines elektronischen Bauteils (1) mit Halbleiterchips (2, 3) in einem Stapel (4), wobei das Verfahren folgende Verfahrensschritte aufweist:
a) Bereitstellen eines Umverdrahtungssubstrats (5) mit Anschlussflächen (6) in einem Mittenbereich (7) für Flipchip-Verbindungen (8) eines unteren Elektronikbausteins (9) und mit Anschlussflächen (60) in Randbereichen (10) des Umverdrahtungssubstrats (5) für Bondverbindungen (11) zu einem oberen Elektronikbaustein (12),
b) Aufbringen des als Halbleiterchip (2) ausgebildeten ersten unteren Elektronikbausteins (9) in Flipchip-Technologie in dem Mittenbereich (7) des Umverdrahtungssubstrats (5),
c) Herstellen wenigstens eines zweiten oberen Elektronikbausteins (12), der einen Halbleiterchip (3) und eine Umverdrahtungsstruktur (13) mit Außenkontaktflächen (14) aufweist,
d) Aufbringen des oberen Elektronikbausteins (12) auf den unteren Elektronikbaustein (9), so dass die passiven Rückseiten (10, 16) des unteren und des oberen Elektronikbausteins (9, 12) aufeinanderliegen,
e) Herstellen von Bondverbindungen (11) zwischen den Außenkontaktflächen (14) des oberen Elektronikbausteins (12) und den Anschlussflächen (60) in den Randbereichen (10) des Umverdrahtungssubstrats (5),
g) Verpacken der Elektronikbausteine (9, 12) unter Aufbringen einer Kunststoffgehäusemasse (17) auf das Umverdrahtungssubstrat (5).

2. Verfahren nach Anspruch 1,
**dadurch gekennzeichnet, dass**
der obere Elektronikbaustein (12) vor seinem Aufbringen auf die passive Rückseite (15) des Halbleiterchips (2) des unteren Elektronikbausteins (9) Prüfungen bei extremen Temperaturbedingungen, insbesondere von -50°C bis 150°C ausgesetzt wird.

3. Verfahren nach Anspruch 1 oder Anspruch 2,
**dadurch gekennzeichnet, dass**
wenigstens ein Logikchip (28) als erster unterer Elektronikbaustein (9) und wenigstens ein Speicherchip (39) und mit Außenkontaktflächen (14) als zweiter oberer Elektronikbaustein (12) eingesetzt werden.

4. Verfahren nach einem der Ansprüche 1 bis 3,
**dadurch gekennzeichnet, dass**
der obere Elektronikbaustein (12) auf die passive Rückseite (15) des unteren Elektronikbausteins (9) geklebt wird.

5. Verfahren nach einem der Ansprüche 1 bis 4,
**dadurch gekennzeichnet, dass**
die Bondverbindungen (11) zwischen den Außenkontakten (14) des oberen Elektronikbausteins (12) und den Anschlussflächen (60) des Umverdrahtungssubstrats (5) mittels Drahtbonden hergestellt werden.

6. Verfahren nach einem der Ansprüche 1 bis 5,
**dadurch gekennzeichnet, dass**
zum Verbinden der Anschlussflächen (60) in den Randbereichen (10) des Umverdrahtungssubstrats (5) mit den Außenkontaktflächen (14) des oberen Elektronikbausteins (12) Bonddrähte (18) zunächst auf den Anschlussflächen (60) und anschließend auf den Außenkontaktflächen (14) gebondet werden.

7. Verfahren nach einem der Ansprüche 1 bis 6,
**dadurch gekennzeichnet, dass**
in die Umverdrahtungsstruktur (13) des oberen Elektronikbausteins (12) ein zentraler Bondkanal (19) eingebracht wird, dessen Bondverbindungen (111) über Bondfinger (20) und über Umverdrahtungsleitungen (21) mit den Außenkontaktflächen (14) elektrisch leitend verbunden werden.

8. Verfahren nach Anspruch 7,
**dadurch gekennzeichnet, dass**
der Bondkanal (19) unter Einbetten der Bondverbindungen (111) von einer Schutzumhüllung (22) aus Kunststoff bedeckt wird.

9. Verfahren nach einem der Ansprüche 1 bis 8,
**dadurch gekennzeichnet, dass**
zur Herstellung eines Umverdrahtungssubstrats (5) eine erste Metallplattierung einer beidseitig metallisierten Leiterplatte (23) mit Anschlussflächen (6) für Flipchip-Verbindungen in einem Mittenbereich (7), mit Anschlussflächen (60) für Bondverbindungen (11) in Randbereichen (10) und mit Umverdrahtungsleitungen (25) zu Durchkontakten (26) strukturiert wird, wobei die Durchkontakte (26) mit Außenkontaktflächen (27) einer strukturierten zweiten Metallplattierung der Leiterplatte (23) elektrisch verbunden werden.

10. Verfahren nach einem der Ansprüche 1 bis 9,
**dadurch gekennzeichnet, dass**
zum Verpacken der Elektronikbausteine ein gefülltes Epoxidharz mittels Transfermoldverfahren auf das Umverdrahtungssubstrat aufgebracht wird.

11. Verfahren nach einem der Ansprüche 1 bis 9,
**dadurch gekennzeichnet, dass**
zum Verpacken der Elektronikbausteine (9, 12) eine Kunststoffgehäusemasse mittels Dispensverfahren auf das Umverdrahtungssubstrat (5) aufgebracht wird.

12. Verfahren nach einem der Ansprüche 6 bis 11,
**dadurch gekennzeichnet, dass**
Außenkontakte (30) auf die Außenkontaktflächen (27) des Umverdrahtungssubstrats (5) aufgebracht werden.

13. Elektronisches Bauteil mit Halbleiterchips in einem Stapel, wobei das elektronische Bauteil (1) folgende Merkmale aufweist:
- ein Umverdrahtungssubstrat (5) mit Anschlussflächen (6) für Flipchip-Verbindungen (8) in einem Mittenbereich (7) und mit Anschlussflächen (60) für Bondverbindungen (11) in Randbereichen (10) des Umverdrahtungssubstrats (5),
- wenigstens ein als Halbleiterchip (2) ausgebildeter erster unterer Elektronikbaustein (9), der Kontaktbereiche (24) aufweist, die in Flipchip-Technologie mit den Anschlussflächen (6) in dem Mittenbereich (7) des Umverdrahtungssubstrats (5) elektrisch verbunden sind,
- wenigstens ein zweiter oberer Elektronikbaustein (12), der einen Halbleiterchip (3) und eine Umverdrahtungsstruktur (13) mit Außenkontaktflächen (14) auf dem Halbleiterchip (3) aufweist, wobei der obere Elektronikbaustein (12) derart auf dem unteren Elektronikbaustein (9) angeordnet ist, dass die passiven Rückseiten (15, 16) der Elektronikbausteine (9, 12) aufeinanderliegen,
- Bondverbindungen (11) zwischen den Außenkontaktflächen (14) des oberen Elektronikbausteins (12) und den Anschlussflächen (60) in den Randbereichen (10) des Umverdrahtungssubstrats (5),
- einem Bauteilgehäuse (29), daß die Elektronikbausteine (9, 12) umgibt.

14. Elektronisches Bauteil nach Anspruch 13,
**dadurch gekennzeichnet, dass**
die Schutzumhüllung (22) zu dem Material des Bauteilgehäuses (29) eine Materialgrenze (38) aufweist.

15. Elektronisches Bauteil nach Anspruch 13 oder Anspruch 14,
**dadurch gekennzeichnet, dass**
der untere Elektronikbaustein (9) als Logikchip (28) ausgebildet ist und dass der obere Elektronikbaustein (12) als Speicherchip (39) mit Umverdrahtungsstruktur (5) und mit Außenkontaktflächen (14) ausgebildet ist.

16. Elektronisches Bauteil nach einem der Ansprüche 13 bis 15,
**dadurch gekennzeichnet, dass**
das Umverdrahtungssubstrat (5) eine beidseitig metallisierte und strukturierte Leiterplatte (23) mit Durchkontakten (26) als elektrische Verbindung zwischen den strukturierten Metallschichten auf der Oberseite und auf der Unterseite der Leiterplatte (23) aufweist, wobei die Unterseite der Leiterplatte Außenkontaktflächen (27) mit Außenkontakten (30) aufweist und wobei die Oberseite der Leiterplatte die Anschlussflächen (6) für Flipchip-Verbindungen (8) in einem Mittenbereich (7), die Anschlussflächen (60) für Bondverbindungen (11) in Randbereichen (10), sowie Umverdrahtungsleitungen (25) zwischen den Anschlussflächen (6, 60) und den Durchkontakten (26) aufweist.

17. Elektronisches Bauteil nach einem der Ansprüche 13 bis 16,
**dadurch gekennzeichnet, dass**
eine Klebstoffschicht (31) zwischen den passiven Rückseiten (15, 16) der Elektronikbausteine (9, 12) angeordnet ist.

18. Elektronisches Bauteil nach einem der Ansprüche 13 bis 17,
**dadurch gekennzeichnet, dass**
der obere Elektronikbaustein (12) eine aktive Oberseite (16) mit einem zentralen Bondkanal (19) mit Bondverbindungen (111) aufweist, wobei die Bondverbindungen (111) über die auf der aktiven Oberseite (32) angeordnete Umverdrahtungsstruktur (13) mit den Außenkontaktflächen (14) verbunden sind.

19. Elektronisches Bauteil nach Anspruch 18,
**dadurch gekennzeichnet, dass**
der Bondkanal (19) mit seinen Bondverbindungen (111) eine Schutzumhüllung (22) aufweist.

20. Elektronisches Bauteil nach einem der Ansprüche 13 bis 19,
**dadurch gekennzeichnet, dass**
die Flächennormale der Anschlussflächen (60) des Umverdrahtungssubstrats (5) und die Flächennormale der Außenkontaktflächen (14) der Umverdrahtungsstruktur (13) in die gleiche Richtung weisen.

21. Elektronisches Bauteil nach einem der Ansprüche 13 bis 20,
**dadurch gekennzeichnet, dass**
die Bondverbindungen (11) einen Bonddraht (18) aufweisen, der einen Bondbogen (34) ausbildet, der von einer der Anschlussflächen (60) des Umverdrahtungssubstrats (5) zu der entsprechenden Außenkontaktfläche (14) des oberen Elektronikbausteins (12) verläuft.
